# EUROPEAN PATENT APPLICATION

(11) **EP 1 811 555 A1**
(43) Date of publication of application: **25.07.2007**
(21) Application number: 05787491.9
(22) Date of filing: 28.09.2005
(51) Int. Cl.: H01L 21/60, C22C 5/02

(54) **Au ALLOY BONDING WIRE**

(30) Priority: 30.09.2004 JP 2004287524
(71) Applicant: TANAKA DENSHI KOGYO KABUSHIKI KAISHA, Tokyo 100-6422 (JP)
(72) Inventor: MURAI, Hiroshi c/o TANAKA DENSHI KOGYO K.K., Saga 842-0031 (JP); CHIBA, Jun c/o TANAKA DENSHI KOGYO K.K., Saga 842-0031 (JP); TESHIMA, Satoshi c/o TANAKA DENSHI KOGYO K.K., Saga 842-0031 (JP)
(74) Representative: Schubert, Klemens
(86) International application number: PCT/JP2005/017819
(87) International publication number: WO 2006/035803

(57) **Abstract**

Provided is a thin Au alloy bonding wire having desired strength, good bondability and stability over time, and improved circularity of a squashed ball and sphericity of a melted ball. The Au alloy bonding wire contains, in an Au alloy matrix containing 0.05 to 2 mass % in total of at least one selected from Pd and Pt of high purity in Au of high purity, as trace elements, 10 to 100 ppm by mass of Mg, 5 to 100 ppm by mass of Ce, and 5 to 100 ppm by mass of each of at least one selected from Be, Y, Gd, La, Eu and Si, the total content of Be, Y, Gd, La, Eu and Si being 5 to 100 ppm by mass, or as trace elements, Mg, Be, and at least one selected from Y, La, Eu and Si, or as trace elements, 10 to 100 ppm by mass of Mg, 5 to 30 ppm by mass of Si, 5 to 30 ppm by mass of Be, and 5 to 30 ppm by mass of at least one selected from Ca, Ce and Sn.

## Description

### BACKGROUND OF THE INVENTION

### 1. Field of the Invention

The present invention relates to Au alloy bonding wires for wire bonding of semiconductor devices used for connecting external leads of circuit boards to electrodes on semiconductor integrated circuit devices, and more specifically relates to an Au alloy bonding wire according to which the bondability for a first bond and a second bond is improved, and an Au alloy bonding wire according to which the sphericity of a melted ball and the circularity of a squashed ball are improved.

### 2. Description of the Related Art

Conventionally, as wires of diameter approximately 25 to 35 µm for connecting external leads to semiconductor chip electrodes used in semiconductor apparatuses, Au alloy bonding wires containing high-purity gold of purity not lower than 99.99 mass % are widely used. Ordinarily, in a method of connecting an Au alloy bonding wire, for a first bond, a combined ultrasonic-thermo compression bonding method is mainly used. With this method, a tip of the wire is heated and thus melted through arc heat input, thus forming a ball by the surface tension, and then the ball portion is squashed onto an electrode of a semiconductor device that has been heated to a range of 150 to 300°C. Then, for a subsequent second bond, the bonding wire is directly wedge-joined onto the external lead side through ultrasonic compression bonding.

In order for a semiconductor device such as a transistor or IC to be usable, after the bonding with bonding wires as described above, sealing with an epoxy resin is carried out with an object of protecting the semiconductor chip, the bonding wires, and the lead frame or the like at a portion where the semiconductor chip is attached.

Recently, there are increased demands to make semiconductor devices more compact and finer, and to improve the performance and reliability thereof. Among this, the properties required of gold bonding wires have become more multifarious, and it has become that even when gold bonding wires are made still finer to cope with the increased number of pins of semiconductor chips and the accompanying reduction in pitch therebetween, still better long term reliability of the bonding is required with regard to the necessary strength, the circularity of the ball for the first bond, the bonding reliability for the second bond, and so on.

In particular, as semiconductor devices are being made still more compact and finer and of yet higher performance, the size of the semiconductor devices is decreased. Accompanying this, the number of input/output terminals per unit area is increased, and the Al pad pitch (the spacing between pad centers) is also decreased from 100 µm to 80 µm and further to 60 µm. The diameter of bonding wires has thus also started to decrease from 25 µm to 23 µm or smaller, and in some cases trials have even been carried out into a wire diameter in the order of 10 µm.

However, as the diameter of bonding wires decreases, the absolute rigidity of the wire itself decreases, and hence problems have started to arise that were not a problem with a wire diameter of 25 µm.

For example, if the rigidity decreases as a result of the wire diameter being decreased, then a so-called "leaning" troubles in which wires stringing between the first bond and the second bond fall down sidewise and hence the gap between adjacent wires decreases arises with eventual contacting.

Moreover, as the density is increased, the amount of heat generated at the bonds increases. If there is prolonged use in a high-temperature ambience, then growth of an intermetallic compound at the interface between the Au wire and the Al pad at the first bond will proceed rapidly, and as a result the problem of the ball bondability decreasing due to the intermetallic compound produced will become marked.

Furthermore, corrosion under the influence of components contained in the molding resin also becomes a problem.

To solve these problems, trials have been carried out into adding various elements in varied proportions. Au alloy wires have been introduced from pure Au wires by adding a noble metal element such as Pd to the Au so as to increase the rigidity, and attempts have been made to improve various properties by adding one or a plurality of trace elements. In one example, growth of an intermetallic compound has been suppressed by retarding Au-Al interdiffusion at the interface between the bonding wire (ball) and the Al alloy to which the bonding wire is joined.

In the case of adding trace elements to an Au alloy wire, the higher the concentration of the trace elements is made relative to the Au alloy wire, the higher the absolute rigidity of the Au alloy wire becomes, and the better various properties become, but on the other hand, undesirable properties also appear. An example is that in the case that the loop formability improves, the Au ball formability worsens due to the elements added to the Au alloy matrix. The wedge bondability may also worsen. Furthermore, the drawback of the Au alloy ball hardness increasing due to the elements added to the Au alloy matrix may also arise.

There are thus problems such as the melted ball or the squashed ball becoming misshapen, and hence it becomes difficult to carry out ball bonding at a small pitch of spacing, or the rate of chip cracking increasing; trace elements can therefore not be added in large amounts. For example, in the case that Ca alone is added to secure strength, the Ca may partially deposit out on the surface of the fine wire, the deposited Ca then being oxidized to form a surface oxide film, and as a result there have been problems of the ball shape and bondability for the first bond not being stable, and hence the circularity of the squashed ball becoming poor, and the wedge bondability for the second bond becoming poor.

Moreover, in a complicated case in which many types of elements are added, these elements may function in a complicated manner in the Au alloy and may be deposited out on the surface of the melted ball, whereby good initial bonding cannot be obtained, and there is an increased tendency for it is no longer possible to obtain a reliable first bond and good bondability for the second bond.

In sum, the present status of the matter is that a balance can be obtained by selecting the kinds and amounts of the alloying elements so as to accomplish the wire properties required of the fine wire; as the wire properties required of the fine wire become upgraded, there is no foreseeable end to the search for combinations.

Following is a brief summary of the additive elements to the bonding wire alloy described in several prior art documents.

Japanese Patent No. 3064692 describes a "semiconductor device bonding wire in which 1 wt% of high-purity Pd is added to high-purity Au, and, in addition, 0.0001 to 0.005 wt%, as a total, of at least one selected from Fe, Si, Be, Ca, Ge, Y, Sc and other rare earth elements is added". Here, a "bonding wire of diameter 25 µm" is given as a working example.

Japanese Patent Application Laid-open No. 9-321075 describes a "bonding wire characterized by containing 0.0003-0.003 wt% of Ca, containing 0.0005 to 0.01 wt% of Mg, and containing 0.01 to 2.0 wt%, as a total, of at least one selected from Pt, Pd and Cu, the balance comprising Au and unavoidable impurities". Here, an "alloy wire of diameter 0.025 mm" is given as a working example.

Japanese Patent Application Laid-open No. 11-222639 describes an "fine wire comprising a gold alloy for bringing semiconductor components into contact with one another, characterized in that the gold alloy comprises 0.5 to 0.9 wt% of copper, 0.05 to 0.95 wt% of platinum, and the balance of gold", and further describes such a gold alloy to which is added "0.0001 to 0.1 wt% of at least one selected from the group consisting of alkaline earth metals and rare earth metals". Here, the "alkaline earth metal(s) is/are beryllium, magnesium and/or calcium", and the "rare earth metal is cerium". Here, "a diameter of 30 µm" is given as a working example.

Japanese Patent Application Laid-open No. 11-87396 describes an "fine wire for bringing semiconductor structural members into contact with one another comprising a gold alloy containing cerium misch metal, characterized in that the gold alloy comprises 0.05 to 0.95 wt% of platinum, 0.001 to 0.1 wt% of cerium misch metal, 0 to 0.1 wt% of an alkaline earth metal, and the balance of gold, wherein at least 50 wt% of the rare earth metal is cerium", and moreover states that "the alkaline earth metal comprises a mixture of beryllium and calcium", and "the platinum is partially or wholly replaced with palladium". Here, regarding prior art, it is stated that "The diameter of the wire can be approximately 10 to 200 µm, and is usually approximately 20 to 60 µm. This is selected in accordance with the purpose of use", and "a wire having a diameter of 30 µm" and "a wire having a diameter of 25 µm and a wire having a diameter of 30 µm" are given as working examples.

Japanese Patent Application Laid-open No. 11-214425 describes a "gold alloy wire for wire bonding of a semiconductor device characterized by adding 0.1 to 3.0 wt% of at least one selected from Zn, Co, Mo and Cr, and 1 to 100 ppm by weight of at least one selected from La, Eu, Be, Y and Ca to high-purity gold", and further states that it is possible to "add 1 to 500 ppm by weight of at least one selected from Bi, Yb, Sb, Mg, In, Ru and Ir", and moreover "further add 0.01 to 2.0 wt% of at least one selected from Pd, Pt, Cu and Ag". Here, "a diameter of 30 µm" is given as a working example.

Japanese Patent Application Laid-open No. 2003-133362 describes "gold alloy bonding wires" for the case that "the molding resin is a resin having a bromine concentration of not exceeding 0.1 mass % and contains 0.01 mass % or more as a total concentration (Rp) of at least one element selected from P, Mg and Al", including a "gold alloy bonding wire" having "C₁ = 0.005 to 1.5 mass %", or a "gold alloy bonding wire" having "C₁ = 0.005 to 1.5 mass %" and "C₂ = 0.001 to 0.06 mass %" and "C₃ = 0.001 to 0.05 mass %", assuming that "C₁ is the total concentration of at least one element selected from Cu, Pd, Pt, Zn and Ag", "C₂ is the total concentration of at least one element selected from Ca, Ce, Eu, Dy and Y", and "C₃ is the total concentration of at least one element selected from La, Gd, Tb, Mg and Ni". Here, "a wire diameter of smaller than 18 µm" is mentioned, but "a final wire diameter of 20 µm" is shown in the working example.

### SUMMARY OF THE INVENTION

It is an object of the present invention to provide a bonding wire according to which, despite being a fine wire having a diameter of not more than 23 µm, trace elements in an Au alloy matrix of Au-Pd or the like can be dispersed uniformly without segregation, Au-Al interdiffusion can be delayed, leaning does not occur, the sphericity of a melted ball is maintained, and moreover a squashed ball has good circularity. Moreover, it is another object of the present invention to provide a bonding wire according to which, due to the content of the trace elements in a suitable amount, even if ball bonding is carried out in the air, there is no formation of an oxide film on the surface of the fine wire or the melted ball, the bondability is good, and there is little tendency for an intermetallic compounds to be produced over time. Furthermore, it is another object of the present invention to provide a bonding wire according to which the wedge bondability of a second bond through ultrasonic compression bonding, which has not been considered much with ball bonding hitherto, is improved. These objects are valid even in the case that the total amount added of trace elements is not larger than 100 ppm.

The inventors have carried out extensive studies to attain the above objects, and as a result have accomplished the present invention.

That is, according to the present invention, Au alloy bonding wires as follows are provided.
(1) An Au alloy bonding wire comprising an Au alloy in which trace elements are contained in an Au alloy matrix containing 0.05 to 2 mass % in total of at least one selected from Pd and Pt of high purity of at least 99.9 mass % in Au of high purity of at least 99.99 mass %, wherein the trace elements comprise 10 to 100 ppm by mass of Mg, 5 to 100 ppm by mass of Ce, and 5 to 100 ppm by mass each of at least one selected from Be, Y, Gd, La, Eu and Si, the total content of Be, Y, Gd, La, Eu and Si being 5 to 100 ppm by mass.
(2) An Au alloy bonding wire comprising an Au alloy in which trace elements are contained in an Au alloy matrix containing 0.05 to 2 mass % in total of at least one selected from Pd and Pt of high purity of at least 99.9 mass % in Au of high purity of at least 99.99 mass %, wherein the trace elements comprise 10 to 100 ppm by mass of Mg, 5 to 100 ppm by mass of Be, and at least one selected from Y, La, Eu and Si, the content of each of Y, La, Eu and Si being 5 to 100 ppm by mass, and the total content of Y, La, Eu and Si being not exceeding 100 ppm by mass.
(3) An Au alloy bonding wire comprising an Au alloy in which trace elements are contained in an Au alloy matrix containing 0.05 to 2 mass % in total of at least one selected from Pd and Pt of high purity of at least 99.9 mass % in Au of high purity of at least 99.99 mass %, wherein the trace elements comprise 10 to 100 ppm by mass of Mg, 5 to 30 ppm by mass of Si, 5 to 30 ppm by mass of Be, and 5 to 30 ppm by mass of either of Ca and Sn.
(4) An Au alloy bonding wire comprising an Au alloy in which trace elements are contained in an Au alloy matrix containing 0.05 to 2 mass % in total of at least one selected from Pd and Pt of high purity of at least 99.9 mass % in Au of high purity of at least 99.99 mass %, wherein the trace elements comprise 10 to 100 ppm by mass of Mg, 5 to 30 ppm by mass of Si, 5 to 30 ppm by mass of Be, and 5 to 30 ppm by mass of each of, and 10 to 60 ppm by mass in total of, two selected from Ca, Ce and Sn.
(5) An Au alloy bonding wire comprising an Au alloy in which trace elements are contained in an Au alloy matrix containing 0.05 to 2 mass % in total of at least one selected from Pd and Pt of high purity of at least 99.9 mass % in Au of high purity of at least 99.99 mass %, wherein the trace elements comprise 10 to 100 ppm by mass of Mg, 5 to 30 ppm by mass of Si, 5 to 30 ppm by mass of Be, and 5 to 30 ppm by mass of each of, and 15 to 90 ppm by mass in total of, all three of Ca, Ce and Sn.
(6) The Au alloy bonding wire according to any of (1) through (5), wherein the total content of the trace elements is not exceeding 100 ppm by mass.
(7) The Au alloy bonding wire according to any of (1) through (5), having a diameter of not exceeding 23 µm.

### Advantages of the Invention

According to the Au alloy of the present invention, even for a fine bonding wire of a diameter not exceeding 23 µm, as in the case that that the diameter is greater than 23 µm, an effect of retarding Au-Al interdiffusion, an effect of improving wedge bondability, an effect of suppressing leaning, an effect of improving the sphericity of the melted ball, and an effect of improving the circularity of a squashed ball can all be attained. In the present invention, it is needless to add the trace elements in an amount exceeding 300 ppm by mass as is conventional, and hence a bonding wire can be realized according to which, even if ball bonding is carried out in air, an oxide film will never be formed on the surface of the fine wire on the melted ball.

### DESCRIPTION OF THE PREFERRED EMBODIMENTS

Au alloy bonding wires of the present invention contain, as a matrix alloy, (i) Au and (ii) Pd and/or Pt; desired properties are obtained through selection and adjustment of trace elements contained in this matrix alloy. The Au alloy bonding wires can be classified broadly into two groups in terms of the properties to be obtained.

For the first group, bondability and stability over time (long term reliability) for the first bond and the second bond are predominantly aimed for, and a first invention and a second invention are stipulated.

For the second group, an improvement in the circularity of a squashed ball, and an improvement in the sphericity of a melted ball which greatly affects the circularity of the squashed ball, are predominantly aimed for, and third to fifth inventions are stipulated.

In the first invention (claim 1) belonging to the first group, as the additive trace elements contained in the matrix alloy, (iii) Mg and Ce are taken as the essential additive trace elements, and these are combined with (iv) at least one element selected from Be, Y, Gd, La, Eu and Si. In the second invention (claim 2) belonging to the first group, as the additive trace elements contained in the matrix alloy, (v) Mg and Be are taken as the essential additive trace elements, and these are combined with (vi) at least one element selected from Y, La, Eu and Si without containing Ce.

In the third invention (claim 3) belonging to the second group, the matrix alloy is the same as in the inventions belonging to the first group, and as the additive trace elements contained in the matrix alloy, (vii) Mg, Si and Be are taken as the essential additive trace elements, and these are combined with (viii) either of Ca and Sn. In the fourth invention (claim 4) belonging to the second group, as the additive trace elements contained in the matrix alloy, (vii) Mg, Si and Be are taken as the essential additive trace elements, and these are combined with (viii) two elements selected from Ca, Ce and Sn. In the fifth invention (claim 5) belonging to the second group, as the additive trace elements contained in the matrix alloy, (vii) Mg, Si and Be are taken as the essential additive trace elements, and these are combined with (ix) the three elements Ca, Ce and Sn.

In the matrix alloy used in the present invention, Au is high-purity Au, the purity thereof being at least 99.99 mass %, preferably at least 99.999 mass %. In addition, the Pd and/or Pt is of high purity, the purity thereof being at least 99.9 mass %, preferably at least 99.99 mass %.

If the alloy contains a large amount of the Pd and/or Pt, then a ball will become harder, and chip cracking will become prone to occur. The total content of the Pd and Pt in the matrix alloy is thus not exceeding 2 mass %, preferably not exceeding 1.5 mass %, of the matrix alloy. Moreover, to produce stable effects, the lower limit of this content is 0.08 mass %, preferably 0.2 mass %.

Besides, Pd and Pt also have an effect on the long-term reliability of the first bond. A high temperature storage at 175°C has indicated the durations of:
· at least 2000 hours at a content of 0.2 mass % or larger;
· at least 1500 hours at a content of 0.08 mass % or larger; and
· at least 1000 hours at a content of 0.05 mass % or larger.

In the case of adding both Pd and Pt to the matrix alloy, there are no particular limitations in the proportion between the amount of Pd added and the amount of Pt added. This is because both Pd and Pt exhibit approximately the same matrix effect on Au.

Among the trace elements dispersed in the matrix alloy (Au alloy), the purity of Mg should be at least 99.9 mass %, preferably at least 99.99 mass %. For both the inventions belonging to the first group and the inventions belonging to the second group, the content of Mg in the matrix alloy is 10 to 100 ppm by mass, preferably 40 to 80 ppm by mass.

It has been found that in the Au alloy matrix, Mg is an element capable of improving the circularity for the first bond and the wedge bondability for the second bond formed by ultrasonic compression bonding. If 10 to 100 ppm by mass of Mg is contained, then the above effects of improving the circularity and the wedge bondability are exhibited. With less than 10 ppm by mass, the circularity and the wedge bondability cannot be improved, and at above 100 ppm by mass, Mg is deposited out on the ball surface and oxidized, and hence the bondability for the first bond worsens. Mg further improves the wedge bondability for the second bond with 40 ppm by mass or higher, and moreover with 80 ppm by mass or lower the sphericity of the melted ball is more stable.

The sphericity for the melted ball in the present invention is defined as the ratio "across diameter to downward diameter" obtained by measuring the respective diameters of the melted ball as viewed from the wire-free end of the melted ball. The value of this sphericity is in a range of 0.99 to 1.01, preferably 0.995 to 1.005. Further, the circularity of the squashed ball is defined as the ratio "compres sion-bonded diameter in perpendicular direction to squashed diameter in parallel direction" upon measuring the respective squashed diameters parallel to and perpendicular to the direction of ultrasonic wave application. The value of this circularity is in the range of 0.98 to 1.02, preferably 0.99 to 1.01.

Among the trace elements contained in the matrix alloy (Au alloy), the purity of Ce should be at least 99.9 mass %, preferably at least 99.99 mass %.

The content of Ce in the matrix alloy is 5 to 100 ppm by mass for the first group, and 5 to 30 ppm by mass for the second group.

Among the trace elements contained in the Au alloy matrix, the purity of Be should be at least 98.5 mass %, preferably at least 99.9 mass %.

The content of Be in the matrix alloy is 5 to 100 ppm by mass for the first group, and 5 to 30 ppm by mass for the second group.

Be in the Au alloy matrix improves the circularity for the first bond. If the Be content is less than 5 ppm by mass, then the above effect of improving the circularity cannot be obtained, whereas if the Be content is greater than 30 ppm by mass, the result is that an increased amount of the oxide is formed on the surface of the melted ball and hence the bondability for the first bond worsens.

Among the trace elements contained in the Au alloy matrix, the purity of Si should be at least 99.99 mass %, preferably at least 99.999 mass %.

The content of Si in the matrix alloy is 5 to 100 ppm by mass for the first group, and 5 to 30 ppm by mass for the second group.

Si in the Au alloy matrix is an element that maintains the loop formability, and the circularity of the squashed ball. If the Si content is less than 5 ppm by mass, then the loop formability cannot be maintained, whereas if the Si content is greater than 30 ppm by mass, then it would be difficult to obtain good circularity.

Among the trace elements contained in the Au alloy matrix, the purity of Gd should be at least 99 mass %, preferably at least 99.5 mass %.

The content of Gd in the matrix alloy is 5 to 100 ppm by mass for the first group.

Gd in the Au alloy matrix is an element that maintains the loop formability, and the circularity of the squashed ball. If the Gd content is lower than 5 ppm by mass, then the loop formability cannot be maintained, whereas if the Gd content is greater than 30 ppm by mass, then it woukd be difficult to obtain good circularity.

Among the trace elements contained in the Au alloy matrix, the purity of Ca should be at least 99 mass %, preferably at least 99.5 mass %. The content of Ca in the matrix alloy is 5 to 30 ppm by mass.

Ca in the Au alloy matrix improves the strength of the wire. It has been found that, even for an fine wire having a diameter of not exceeding 23 µm, Ca increases the rigidity of the fine wire itself, whereby the loop formability can be maintained, and moreover the circularity of the squashed ball in the first bonding can be maintained. If the Ca content is lower than 5 ppm by mass, then the above effect of improving the circularity cannot be obtained. If the Ca content is greater than 30 ppm by mass, then a depression will be prone to be formed in the base of the melted ball, and hence for a bonding wire that is used in ball bonding by forming a melted ball and then connecting to an electrode of a semiconductor device, the Ca content in the matrix alloy is preferably in the range of 5 to 30 ppm by mass.

Moreover, if a prescribed amount of Ca is added, then a wire for which good loop formability and circularity are simultaneously fulfilled can be obtained.

Furthermore, if the total content of all the trace elements in the Au alloy matrix is greater than 100 ppm by mass, then oxides are prone to be produced on the surface of the melted ball, and hence the bondability for the first bond will worsen.

Among the trace elements contained in the matrix alloy (Au alloy), the purity of each of the elements Ce, Y, Eu, La and Sn should be at least 99.9 mass %, preferably at least 99.99 mass %.

The content of each trace elements in the matrix alloy is 5 to 100 ppm by mass, preferably 5 to 80 ppm by mass for La, and 5 to 30 ppm by mass for the other elements.

As described above, it has been found that, even for a fine wire of diameter not exceeding 23 µm, Ce, Y, Gd, Be, La, Si and Eu in the Au alloy matrix are elements that increase the rigidity of the fine wire itself, whereby the loop formability can be maintained, and moreover the circularity of the squashed ball in the first bonding can be maintained.

If the amount of each element among Ce, and Y, Gd, Be, La, Si and Eu is smaller than 5 ppm by mass, then it will not be possible to maintain the loop formability of the alloy wire of Au-Pd or the like, and moreover it will be difficult to maintain the circularity of the squashed ball in the first bonding. Moreover, if the amount of each of the above elements is larger than 100 ppm by mass, or the total amount of these elements is larger than 100 ppm by mass, then the melted ball will become misshapen, or the rigidity of the fine wire itself will become too high, and hence the semiconductor chip will become prone to breaking. If the content of each of the above elements is not more than 30 ppm by mass, then the circularity of the squashed ball will be yet more stable.

Moreover, the trace elements may be deposited out on the surface of the melted ball of the Au alloy matrix of Au-Pd or the like and oxidized, resulting in the bondability for the first bond worsening, or the circularity of the squashed ball worsening. The order of the effect of improving the circularity has been found to be, from the best to the worst, Si, Be, La, Ce, Ca, Eu, Y and Gd. That is, in combinations with Ce, the order is Ce-Si, Ce-Be, Ce-La, Ce-Y, and Ce-Gd. Moreover, in combinations with Be, the order is Be-Si, Be-Ca, Be-Eu, and Be-Y.

The trace elements Mg, Ce, Y, Gd, Be, Ca, Eu, La and Si used in the present invention are added in trace amounts in a suitable combination to the alloy of high-purity Au-Pd or the like, and hence can be contained uniformly in the Au alloy without segregation; there is thus no unintentional deposition out to form an oxide film on the surface of the Au alloy as with Zn or a large amount of Ca being added alone. Accordingly, by combining Mg, Ce, Y, Gd, Be, Ca, Eu, La and Si in amounts in suitable ranges as above, in addition to an effect of retarding interdiffusion in the Au alloy bonding wire, an effect of improving the wedge bondability, and an effect of improving the sphericity of the melted ball, an effect of loop formation for the fine wire, and an effect of improving the circularity of the squashed ball can all be attained.

Hitherto, joint addition of Mg and a rare earth element to an Au-Pd alloy bonding wire has been disclosed in the literature (Japanese Patent Application Laid-open No. 11-222639, Japanese Patent Application Laid-open No. 11-87396, Japanese Patent Application Laid-open No. 11-214425, Japanese Patent Application Laid-open No. 2003-133362), and there is a case in which this joint addition has actually been carried out (Japanese Patent Application Laid-open No. 2003-133362). However, with the Au alloy containing Zn described in Japanese Patent Application Laid-open No. 11-222639, an oxide film readily forms on the fine wire, and hence the finer the fine wire, the more difficult it becomes to make the squashed ball circular. Moreover, with an Au alloy containing more than 30 ppm by mass of Ca, the Ca deposits out onto the surface irregularly and oxidizes regardless of whether or not other added elements are present, and hence with the Au alloy matrix there is the problem that good bonding reliability for the first bond and good circularity of the squashed ball cannot be obtained.

Hitherto, it was not known that Mg and so on are elements having good dispersibility in an Au alloy matrix of high-purity Au-Pd or the like, and are trace elements for which there is no formation of an oxide film on the surface of the fine wire or the melted ball even if ball bonding is carried out in the air. It was not predictable that by combining suitable ones selected from Mg, Ce, Y, Gd, Be, La, Si, Ca and Eu in amounts in suitable ranges as in the present invention, these trace elements would all have good dispersibility in the Au alloy matrix, with deposition out onto the surface not occurring, and hence stability in the quality as a bonding wire could be obtained.

### [Working examples]

Following is a more detailed description of the present invention by way of working examples and comparative examples.

### [Working Examples 1 to 81]

The composition of each sample is shown in Table 1 for the working examples of the first group (Working Examples 1 to 57) and in Table 2 for the working examples of the second group (Working Examples 58 to 81). Trace elements were added such that the amounts (ppm by mass) thereof would be as in Table 1 or Table 2 to an alloy of high-purity Au of purity 99.999 mass % or more and high-purity Pd and/or Pt of purity 99.99 mass %, or more and melt-casting was carried out in a vacuum melting furnace. Drawing into a wire was then carried out, and then final heat treatment was carried out at a wire diameter of 25 µm, 20 µm or 15 µm, and the elongation was adjusted to 4%. The ultimate elongation and tensile strength of each bonding wire were evaluated by carrying out tensile testing on 10 of each of the wires cut in a length of 10 cm, and then calculating the average values.

Connection was carried out in which each type of fine wire was subjected to first bonding to a 50 µm-square Al pad (Al film thickness approximately 1 µm) on an Si chip by way of ball bonding with a joint ultrasonic-thermocompression bonding method in the air, and was then subjected to second bonding to an Ag-plated 42 alloy lead using wedge bonding with a joint ultrasonic-thermocompression bonding method. At this time, the loop span was made to be 5 mm, and the loop height was made to be 200 µm, and a "200-pin QFP (package)" having 200 Al pads was used. In the first bonding, all of the balls were formed within the 50 µm -square Al pad. Moreover, in the second bonding, the wires were all firmly joined onto leads. Out of the connected wires, the evaluation of each item was carried out using 40 wires freely taken from the thus connected wires. The evaluation results are shown in Table 4 for the working examples of the first group, and Table 5 for the working examples of the second group.

### [Comparative Examples 1 to 23]

The compositions of the samples in these comparative examples having a formulation of the trace elements differing from those of the working examples are each shown in Table 3. Note that Comparative Examples 1 to 17 are comparative examples corresponding to the first group, and Comparative Examples 18 to 23 are comparative examples corresponding to the second group.

The fine wires of Au alloys were subjected, in the same manner as in the working examples, to a final heat treatment to adjust the elongation to 4% at a wire diameter of 25, 20 or 15 µm and subjected to evaluation in the same manner as in Example 1. The results of evaluation are shown in Table 6.

The properties of each bonding wire of the working examples and comparative examples were evaluated as follows.

For the evaluation of the "quality of bonding" for the first bonding and the second bonding, 5000 loops were formed, and the case where there were no defects such as separation was taken as good and indicated by "⊚", the case that defects occurred for one and only one wire was indicated by "O", and the case where defects occurred for two or more wires was indicated by "Δ".

For the "amount of Au-Al formed", the Al pad was dissolved in a 10% aqueous NaOH solution, the bonding surface was observed with a scanning electron microscope, and the proportion of the area where an Au-Al alloy had been formed on the bonding surface was determined. The case where Au-Al had formed on at least 70% of the bonding surface was taken as very good and indicated by "⊚", the case where Au-Al had formed on at least 50% but less than 70% of the bonding surface was taken as good and indicated by "O", and the case where Au-Al had formed on less than 50% of the bonding surface was taken as normal and indicated by "Δ".

For the evaluation of the "sphericity of melted ball", the across and down diameters of the underside of the melted ball (with the wire being on the upper side) were measured, and the case where the ratio therebetween was in the range of 0.995 to 1.005 was indicated by "⊚", and the case where the ratio therebetween was in the range of 0.99 to 1.01 excluding the above range was indicated by "O". The case where the ratio was outside these ranges was indicated by "Δ". The measurement was carried out by selecting ten samples in each case; the average value is shown. However, for Working Examples 58, 62 and 72, the number of samples was increased to 50, whereby the extent of variation for the second group could be determined more accurately.

For the evaluation of the "circularity of squashed ball", the squashed diameter was measured parallel to and perpendicular to the direction in which the ultrasonic waves were applied, and the case where the ratio therebetween was in a range of 0.99 to 1.01 was indicated by "⊚", and the case where the ratio therebetween was in a range of 0.98 to 1.02 excluding the above range was indicated by "O". The case where the ratio was outside these ranges was indicated by "Δ". The measurement was carried out by selecting 200 samples for the first group and 5000 samples for the second group; the average value is shown.

For the "pull test" evaluation, the approximate center of the loop span was hooked upward, and the load at breakage was measured. When the wire diameter was 25 µm, the case where the load was 6x10 mN or larger was indicated by "⊚", the case where the load was in the range of 4x10 to 6x10 mN was indicated by "○", and the case where the load was smaller than 4x10 mN was indicated by "Δ".

Besides, when the wire diameter was 20 µm, the case where the load was 6x10 mN or larger was indicated by "⊚", the case where the load was in a range of 2.5x10 to 4x10 mN was indicated by "○", and the case twhere the load was smallers than 2.5x10 mN was indicated by "Δ". Further, when the wire diameter was 15 µm, the case where the load was 2x10 mN or larger was indicated by "⊚", the case where the load was in the range of 1 × 10 to 2×10 mN was indicated by "○", and the case where the load was smaller than 1×10 mN was indicated by "Δ".

For the "overall evaluation", the cases in which, out of the above six evaluation items, there were three or more "⊚" marks and no "Δ" marks were taken as particularly good and indicated by "⊚", cases where there were two or fewer "⊚" but no "Δ" were taken as good and indicated by "○", and cases where there was one or more "Δ" were taken as normal and indicated by "Δ".

**[Table1]**

| Example No. | Au | Pd | Pt | Mg | Ce | Be | Y | Gd | La | Eu | Si | Sn | Ca | Zn |
|---|---|---|---|---|---|---|---|---|---|---|---|---|---|---|
| | | mass % | | mass ppm | | | | | | | | | | |
| 1 | balance | 0.5 | | 10 | 10 | | 10 | | | | | | | |
| 2 | balance | 1 | | 10 | 80 | | | 50 | | | | | | |
| 3 | balance | 1.5 | | 10 | 10 | | | | 50 | | | | | |
| 4 | balance | | 0.5 | 10 | 80 | | | | | 80 | | | | |
| 5 | balance | | 1 | 10 | | 10 | 80 | | | | | | | |
| 6 | balance | | 0.5 | 10 | | 80 | | | 50 | | | | | |
| 7 | balance | 0.5 | 0.5 | 10 | | 10 | | | | 10 | | | | |
| 8 | balance | 1 | 0.5 | 10 | | 80 | | | | | 10 | | | |
| 9 | balance | 0.5 | | 30 | 30 | | 10 | | | | | | | |
| 10 | balance | | 1 | 30 | 30 | | | 10 | | | | | | |
| 11 | balance | | 1.5 | 30 | 30 | | | | 10 | | | | | |
| 12 | balance | | 0.5 | 30 | 50 | | | | | 10 | | | | |
| 13 | balance | 1 | | 30 | 50 | | | | | | 10 | | | |
| 14 | balance | 0.5 | | 30 | 10 | | 30 | | | | | | | |
| 15 | balance | 1 | | 30 | 10 | | | 30 | | | | | | |
| 16 | balance | 1.5 | | 30 | 80 | | | | 50 | | | | | |
| 17 | balance | | 1 | 30 | 80 | | | | | 50 | | | | |
| 18 | balance | | 1.5 | 30 | 10 | | | | | | 80 | | | |
| 19 | balance | | 0.5 | 30 | | 30 | 10 | | | | | | | |
| 20 | balance | | 1 | 30 | | 30 | | | 10 | | | | | |
| 21 | balance | | 0.5 | 30 | | 50 | | | | 10 | | | | |
| 22 | balance | 0.5 | 0.5 | 30 | | 50 | | | | | 10 | | | |
| 23 | balance | 0.5 | 1 | 30 | | 10 | 30 | | | | | | | |
| 24 | balance | 0.5 | | 30 | | 10 | | | 50 | | | | | |
| 25 | balance | 1 | | 30 | | 80 | | | | 50 | | | | |
| 26 | balance | 1.5 | | 30 | | 10 | | | | | 80 | | | |
| 27 | balance | 0.5 | | 80 | 80 | | 10 | | | | | | | |
| 28 | balance | 1 | | 80 | 80 | | | 10 | | | | | | |
| 29 | balance | 0.5 | | 80 | 80 | | | | 10 | | | | | |
| 30 | balance | 1 | | 80 | 30 | | | | | 10 | | | | |
| 31 | balance | 1.5 | | 80 | 50 | | | | | | 10 | | | |
| 32 | balance | | 0.5 | 80 | 10 | | 30 | | | | | | | |
| 33 | balance | | 1 | 80 | 30 | | | 30 | | | | | | |
| 34 | balance | | 1.5 | 80 | 50 | | | | 50 | | | | | |
| 35 | balance | | 0.5 | 80 | 50 | | | | | 50 | | | | |
| 36 | balance | 0.5 | 0.5 | 80 | 10 | | | | | | 80 | | | |
| 37 | balance | | 0.5 | 80 | | 30 | 10 | | | | | | | |
| 38 | balance | | 1 | 80 | | 30 | | | 10 | | | | | |
| 39 | balance | | 1.5 | 80 | | 50 | | | | 10 | | | | |
| 40 | balance | 0.5 | | 80 | | 50 | | | | | 10 | | | |
| 41 | balance | 0.5 | 0.5 | 80 | | 10 | 30 | | | | | | | |
| 42 | balance | 1 | 0.5 | 80 | | 10 | | | 50 | | | | | |
| 43 | balance | 0.5 | | 80 | | 80 | | | | 50 | | | | |
| 44 | balance | 1 | | 80 | | 10 | | | | | 80 | | | |
| 45 | balance | 1.5 | | 10 | 30 | | 10 | 10 | 10 | 10 | 10 | | | |
| 46 | balance | 0.5 | | 30 | 80 | | 30 | | 30 | | 30 | | | |
| 47 | balance | 1 | | 50 | 10 | | 20 | | 20 | 20 | 20 | | | |
| 48 | balance | | 0.5 | 50 | | 30 | 10 | 10 | 10 | 10 | 10 | | | |
| 49 | balance | | 1 | 80 | | 80 | 30 | | 30 | | 30 | | | |
| 50 | balance | 0.5 | 1.5 | 80 | | 10 | 20 | 20 | 20 | | 20 | | | |
| 51 | balance | 0.08 | | 50 | 10 | 10 | | | | | 10 | | | |
| 52 | balance | | 0.1 | 40 | 20 | 20 | | 10 | | | | | | |
| 53 | balance | 0.1 | 0.05 | 40 | | 15 | | | 20 | | | | | |
| 54 | balance | 1 | 0.7 | 20 | 60 | | | | | 10 | | | | |
| 55 | balance | 0.6 | 1 | 20 | | 50 | 20 | | | | | | | |
| 56 | balance | 1 | | 50 | | 10 | | | | | 10 | | | |
| 57 | balance | | 0.5 | 20 | | 10 | | | | | 20 | | | |

**[Table 2]**

| Example No. | Au | Pd | Pt | Mg | Ce | Be | Y | Gd | La | Eu | Si | Sn | Ca | Zn |
|---|---|---|---|---|---|---|---|---|---|---|---|---|---|---|
| | | mass % | | mass ppm | | | | | | | | | | |
| 58 | balance | 1 | | 50 | | 10 | | | | | 10 | | 10 | |
| 59 | balance | 1 | | 80 | | 20 | | | | | 10 | | 20 | |
| 60 | balance | 1. 5 | | 30 | 10 | 10 | | | | | 20 | 10 | | |
| 61 | balance | | 0.5 | 50 | 20 | 15 | | | | | 10 | | 10 | |
| 62 | balance | | 1 | 20 | | 20 | | | | | 20 | 10 | | |
| 63 | balance | | 0.5 | 80 | | 10 | | | | | 10 | 20 | | |
| 64 | balance | 0.5 | 0.5 5 | 20 | | 20 | | | | | 20 | 25 | 20 | |
| 65 | balance | 1 | 0.5 5 | 20 | 10 | 10 | | | | | 10 | | 15 | |
| 66 | balance | 0.5 | | 30 | 25 | 15 | | | | | 20 | | 25 | |
| 67 | balance | | 1 | 30 | | 20 | | | | | 10 | 20 | 10 | |
| 68 | balance | | 1. 5 | 30 | 25 | 10 | | | | | 20 | 25 | 25 | |
| 69 | balance | | 0.5 5 | 30 | 20 | 20 | | | | | 10 | | 20 | |
| 70 | balance | 1 | | 30 | 10 | 15 | | | | | 20 | 20 | 25 | |
| 71 | balance | 0.2 | | 50 | 10 | 10 | | | | | 10 | | 10 | |
| 72 | balance | 1 | | 20 | 15 | 15 | | | | | 15 | 10 | 10 | |
| 73 | balance | 1 | 0.5 5 | 30 | 25 | 10 | | | | | 20 | 15 | 25 | |
| 74 | balance | | 1 | 50 | 20 | 20 | | | | | 10 | | 25 | |
| 75 | balance | | 1. 5 | 80 | 10 | 15 | | | | | 20 | 20 | 10 | |
| 76 | balance | | 0.5 5 | 25 | 15 | 10 | | | | | 10 | 10 | 25 | |
| 77 | balance | | 1 | 80 | 10 | 20 | | | | | 20 | | 20 | |
| 78 | balance | | 0.08 | 80 | 25 | 20 | | | | | 20 | 10 | 20 | |
| 79 | balance | 0. | 5 0.5 | 80 | 20 | 20 | | | | | 10 | 10 | 10 | |
| 80 | balance | 0.5 | 1 | 15 | | 10 | | | | | 10 | 20 | 10 | |
| 81 | balance | 0.1 | | 50 | 10 | 10 | | | | | 10 | | 10 | |

**[Table 3]**

| Comp. Example No. | Au | Pd | Pt | Mg | Ce | Be | Y | Gd | La | Eu | Si | Sn | Ca | Zn |
|---|---|---|---|---|---|---|---|---|---|---|---|---|---|---|
| | | mass % | | mass ppm | | | | | | | | | | |
| 1 | balance | 1 | | 10 | 80 | | | 50 | | | | | 50 | |
| 2 | balance | | 0.5 | 10 | 80 | | | | | 80 | | | | 80 |
| 3 | balance | | 0.5 | 10 | 150 | 80 | | | 50 | | | | | |
| 4 | balance | 1 | | | | 10 | | | | 10 | | | | 10 |
| 5 | balance | 1.5 | | 10 | | | | | | | 10 | | 80 | |
| 6 | balance | 0.5 | | 30 | | | | 10 | | | | | | 10 |
| 7 | balance | | 1 | 30 | 30 | | | | | | | | | |
| 8 | balance | | 0.5 | | | 30 | 10 | | | | | | | |
| 9 | balance | | 1 | 30 | | | | | 10 | | | | | |
| 10 | balance | | 0.5 | 30 | | 50 | | | | | | | | |
| 11 | balance | | 1 | 30 | | 150 | | | | | 10 | | | |
| 12 | balance | 1.5 | | 30 | | 10 | | | | | 150 | | | |
| 13 | balance | 0.5 | | 80 | 150 | | 10 | | | | | | | |
| 14 | balance | 1 | | 150 | 80 | | | 10 | | | | | | |
| 15 | balance | 1.55 | | 50 | 10 | | 30 | 30 | 30 | 30 | 30 | | | |
| 16 | balance | | 1.5 | 80 | | 10 | 80 | 80 | | | | | | |
| 17 | balance | | 0.01 | 20 | 80 | | | 15 | | | | | | |
| 18 | balance | | 1 | 6 | 3 | 5 | | | | | 16 | | | |
| 19 | balance | 0.2 | 0.2 | 52 | | 8 | | | | | 28 | | 120 | |
| 20 | balance | 1.3 | 0.3 | 130 | | 18 | | | | | 18 | 22 | 46 | |
| 21 | balance | | 1 | 83 | 38 | 13 | | | | | 23 | 25 | 53 | |
| 22 | balance | 0.01 | | 35 | | | | | | | | | 55 | |
| 23 | balance | 1 | 2 | 46 | 8 | 10 | | | | | 16 | 8 | 8 | |

**[Table 4]**

| Example No. | wire diameter (µm) | molten ball sphericity | press-bond ball circularity | first bond | Au-Al formed | second bond | pull test | overall |
|---|---|---|---|---|---|---|---|---|
| 1 | 25 | ⊚ | ⊚ | ⊚ | ⊚ | ○ | ○ | ⊚ |
| 2 | 25 | ○ | ○ | ○ | ○ | ○ | ○ | ○ |
| 3 | 25 | ⊚ | ○ | ⊚ | ○ | ○ | ○ | ○ |
| 4 | 20 | ○ | ○ | ○ | ○ | ○ | ○ | ○ |
| 5 | 20 | ○ | ○ | ○ | ○ | ○ | ○ | ○ |
| 6 | 20 | ○ | ○ | ○ | ○ | ○ | ○ | ○ |
| 7 | 15 | ⊚ | ⊚ | ⊚ | ⊚ | ○ | ○ | ⊚ |
| 8 | 15 | ○ | ○ | ○ | ○ | ○ | ○ | ○ |
| 9 | 15 | ⊚ | ⊚ | ⊚ | ⊚ | ○ | ○ | ⊚ |
| 10 | 25 | ⊚ | ⊚ | ⊚ | ⊚ | ○ | ○ | ⊚ |
| 11 | 25 | ⊚ | ⊚ | ⊚ | ○ | ○ | ○ | ⊚ |
| 12 | 25 | ⊚ | ○ | ⊚ | ⊚ | ○ | ○ | ⊚ |
| 13 | 20 | ⊚ | ○ | ⊚ | ⊚ | ○ | ○ | ⊚ |
| 14 | 20 | ⊚ | ⊚ | ⊚ | ⊚ | ○ | ○ | ⊚ |
| 15 | 20 | ⊚ | ⊚ | ⊚ | ⊚ | ○ | ○ | ⊚ |
| 16 | 20 | ○ | ○ | ○ | ○ | ○ | ○ | ○ |
| 17 | 15 | ○ | ○ | ○ | ○ | ○ | ○ | ○ |
| 18 | 15 | ○ | ⊚ | ○ | ○ | ○ | ○ | ○ |
| 19 | 15 | ⊚ | ⊚ | ⊚ | ⊚ | ○ | ○ | ⊚ |
| 20 | 15 | ⊚ | ⊚ | ⊚ | ⊚ | ○ | ○ | ⊚ |
| 21 | 15 | ⊚ | ○ | ⊚ | ⊚ | ○ | ○ | ⊚ |
| 22 | 15 | ⊚ | ○ | ⊚ | ⊚ | ○ | ○ | ⊚ |
| 23 | 15 | ⊚ | ⊚ | ⊚ | ○ | ○ | ○ | ⊚ |
| 24 | 25 | ⊚ | ○ | ⊚ | ⊚ | ○ | ○ | ⊚ |
| 25 | 25 | ○ | ○ | ○ | ○ | ○ | ○ | ○ |
| 26 | 25 | ○ | ⊚ | ○ | ○ | ○ | ○ | ○ |
| 27 | 25 | ○ | ○ | ○ | ○ | ⊚ | ⊚ | ○ |
| 28 | 25 | ○ | ○ | ○ | ○ | ⊚ | ⊚ | ○ |
| 29 | 25 | ○ | ○ | ○ | ○ | ⊚ | ⊚ | ○ |
| 30 | 25 | ⊚ | ⊚ | ⊚ | ⊚ | ⊚ | ⊚ | ⊚ |
| 31 | 25 | ⊚ | ○ | ⊚ | ○ | ⊚ | ⊚ | ⊚ |
| 32 | 20 | ⊚ | ⊚ | ⊚ | ⊚ | ⊚ | ⊚ | ⊚ |
| 33 | 20 | ⊚ | ⊚ | ○ | ⊚ | ⊚ | ⊚ | ⊚ |
| 34 | 20 | ⊚ | ○ | ⊚ | ○ | ⊚ | ⊚ | ⊚ |
| 35 | 20 | ⊚ | ○ | ⊚ | ⊚ | ⊚ | ⊚ | ⊚ |
| 36 | 20 | ○ | ⊚ | ○ | ○ | ⊚ | ⊚ | ⊚ |
| 37 | 20 | ⊚ | ⊚ | ⊚ | ⊚ | ⊚ | ⊚ | ⊚ |
| 38 | 20 | ⊚ | ⊚ | ⊚ | ⊚ | ⊚ | ⊚ | ⊚ |
| 39 | 20 | ⊚ | ○ | ⊚ | ○ | ⊚ | ⊚ | ⊚ |
| 40 | 25 | ⊚ | ○ | ⊚ | ⊚ | ⊚ | ⊚ | ⊚ |
| 41 | 25 | ⊚ | ⊚ | ⊚ | ⊚ | ⊚ | ⊚ | ⊚ |
| 42 | 25 | ⊚ | ○ | ⊚ | ○ | ⊚ | ⊚ | ⊚ |
| 43 | 25 | ○ | ○ | ○ | ○ | ⊚ | ⊚ | ○ |
| 44 | 25 | ○ | ⊚ | ○ | ○ | ⊚ | ⊚ | ⊚ |
| 45 | 25 | ⊚ | ⊚ | ⊚ | ○ | ○ | ○ | ⊚ |
| 46 | 25 | ○ | ○ | ○ | ○ | ○ | ○ | ○ |
| 47 | 15 | ⊚ | ⊚ | ⊚ | ⊚ | ⊚ | ○ | ⊚ |
| 48 | 15 | ⊚ | ⊚ | ⊚ | ⊚ | ⊚ | ○ | ⊚ |
| 49 | 15 | ○ | ○ | ○ | ○ | ⊚ | ○ | ○ |
| 50 | 25 | ⊚ | ⊚ | ⊚ | ○ | ⊚ | ⊚ | ⊚ |
| 51 | 15 | ⊚ | ⊚ | ○ | ⊚ | ⊚ | ○ | ⊚ |
| 52 | 15 | ○ | ○ | ⊚ | ○ | ○ | ⊚ | ⊚ |
| 53 | 20 | ○ | ○ | ⊚ | ○ | ⊚ | ⊚ | ⊚ |
| 54 | 20 | ○ | ○ | ○ | ⊚ | ○ | ○ | ○ |
| 55 | 25 | ○ | ○ | ○ | ○ | ○ | ⊚ | ○ |
| 56 | 25 | ⊚ | ⊚ | ○ | ⊚ | ⊚ | ○ | ⊚ |
| 57 | 15 | ⊚ | ⊚ | ⊚ | ⊚ | ○ | ○ | ⊚ |

**[Table 5]**

| Example No. | wire diameter (µm) | molten ball sphericity | prass-bond ball circularity | first bond | Au-AI formed | second bond | pull test put! test | overall |
|---|---|---|---|---|---|---|---|---|
| 58 | 25 | ⊚ | ⊚ | ⊚ | ⊚ | ⊚ | ⊚ | ⊚ |
| 59 | 20 | ○ | ○ | ⊚ | ○ | ⊚ | ○ | ○ |
| 60 | 20 | ⊚ | ⊚ | ○ | ⊚ | ○ | ⊚ | ⊚ |
| 61 | 20 | ⊚ | ⊚ | ⊚ | ⊚ | ⊚ | | ⊚ |
| 62 | 15 | ⊚ | ○ | ○ | ○ | ○ | ○ | ○ |
| 63 | 15 | ○ | ○ | ⊚ | ⊚ | ⊚ | ○ | ⊚ |
| 64 | 15 | ○ | ○ | ⊚ | ○ | ○ | ○ | ○ |
| 65 | 25 | ⊚ | ⊚ | ○ | ⊚ | ○ | ○ | ⊚ |
| 66 | 25 | ○ | ○ | ⊚ | ○ | ○ | ○ | ○ |
| 67 | 25 | ⊚ | ○ | ○ | ○ | ○ | ⊚ | ○ |
| 68 | 20 | ○ | ○ | ○ | ○ | ○ | ○ | ○ |
| 69 | 20 | ○ | ○ | ⊚ | ○ | ○ | ⊚ | ○ |
| 70 | 20 | ○ | ○ | ⊚ | ○ | ○ | ○ | ○ |
| 71 | 20 | ⊚ | ⊚ | ⊚ | ⊚ | ⊚ | ⊚ | ⊚ |
| 72 | 15 | ⊚ | ⊚ | ⊚ | ⊚ | ○ | ○ | ⊚ |
| 73 | 15 | ○ | ○ | ○ | ○ | ○ | ○ | ○ |
| 74 | 15 | ○ | ○ | ○ | ○ | ⊚ | ○ | ○ |
| 75 | 15 | ○ | ○ | ○ | ⊚ | ⊚ | ○ | ○ |
| 76 | 15 | ⊚ | ○ | ⊚ | ○ | ○ | ○ | ○ |
| 77 | 15 | ○ | ○ | ○ | ○ | ⊚ | ○ | ○ |
| 78 | 15 | ○ | ○ | ⊚ | ○ | ⊚ | ○ | ○ |
| 79 | 15 | ○ | ○ | ⊚ | ○ | ⊚ | ○ | ○ |
| 80 | 15 | ⊚ | ⊚ | ○ | ⊚ | ○ | ○ | ⊚ |
| 81 | 15 | ⊚ | ⊚ | ⊚ | ⊚ | ⊚ | ⊚ | ⊚ |

**[Table 6]**

| Comp. Example No. | wire diameter (µm) | molten ball sphericity | press-bond ball circularity | first bond | Au-Al formed | second bond | pull test | overall |
|---|---|---|---|---|---|---|---|---|
| 1 | 15 | ○ | Δ | ○ | ○ | ○ | ○ | Δ |
| 2 | 25 | ○ | Δ | ○ | ○ | ○ | ○ | Δ |
| 3 | 20 | Δ | Δ | Δ | Δ | ○ | ○ | Δ |
| 4 | 15 | ○ | Δ | ○ | ○ | Δ | Δ | Δ |
| 5 | 25 | ○ | Δ | ○ | ○ | ○ | ○ | Δ |
| 6 | 20 | ○ | Δ | ○ | ○ | ○ | ○ | Δ |
| 7 | 15 | ○ | Δ | ○ | ○ | ○ | ○ | Δ |
| 8 | 25 | ⊚ | ⊚ | ⊚ | ⊚ | Δ | Δ | Δ |
| 9 | 20 | ○ | Δ | ○ | ○ | ○ | ○ | Δ |
| 10 | 15 | ○ | Δ | ○ | ○ | ○ | ○ | Δ |
| 11 | 25 | Δ | Δ | Δ | Δ | ○ | ○ | Δ |
| 12 | 20 | Δ | ○ | Δ | Δ | ○ | ○ | Δ |
| 13 | 15 | Δ | Δ | Δ | Δ | ○ | ○ | Δ |
| 14 | 25 | ○ | ○ | ○ | ○ | Δ | Δ | Δ |
| 15 | 20 | Δ | Δ | Δ | Δ | ⊚ | ○ | Δ |
| 16 | 15 | Δ | Δ | Δ | Δ | ○ | ○ | Δ |
| 17 | 25 | ○ | ○ | ○ | ⊚ | ○ | Δ | Δ |
| 18 | 20 | ⊚ | ○ | ⊚ | ⊚ | Δ | Δ | Δ |
| 19 | 15 | Δ | Δ | Δ | Δ | ○ | Δ | Δ |
| 20 | 15 | Δ | Δ | ○ | ○ | ○ | ○ | Δ |
| 21 | 15 | Δ | Δ | Δ | Δ | ○ | Δ | Δ |
| 22 | 15 | Δ | Δ | Δ | Δ | ○ | Δ | Δ |
| 23 | 15 | ⊚ | ⊚ | Δ | Δ | Δ | Δ | Δ |

It is clear from the above results that, for the Au alloy bonding wires of the present invention, when the amounts added of the trace elements are within the specified ranges, satisfactory bonding results are obtained even in the case that the diameter of the fine wire is 23 µm or smaller.

In contrast thereto, for each of the comparative examples, the intended properties were not obtained for reasons as follows.

For the comparative examples corresponding to the first group:
for Comparative Example 1, because the Au alloy bonding wire contains the trace element Ca, which is not included under the present invention;
for Comparative Example 2, because the Au alloy bonding wire contains the trace element Zn, which is not included under the present invention;
for Comparative Example 3, because the content of the trace element Ce exceeds the specified amount;
for Comparative Example 4, because the Au alloy bonding wire contains the trace element Zn, which is not included under the present invention, and does not contain the trace element Mg, which is included under the present invention;
for Comparative Example 5, because the Au alloy bonding wire contains the trace element Ca, which is not included under the present invention;
for Comparative Example 6, because the Au alloy bonding wire contains the trace element Zn, which is not included under the present invention;
for Comparative Example 7, because the Au alloy bonding wire does not contain a trace element other than Mg and Ce included under the present invention;
for Comparative Example 8, because the Au alloy bonding wire does not contain the trace element Mg, which is included under the present invention;
for Comparative Example 9, because the Au alloy bonding wire does not contain a combination with the trace element Ce or Be, which is included under the present invention;
for Comparative Example 10, because the Au alloy bonding wire does not contain a trace element other than Mg and Be included under the present invention;
for Comparative Example 11, because the content of the trace element Be exceeds the specified amount;
for Comparative Example 12, because the content of the trace element Si exceeds the specified amount;
for Comparative Example 13, because the content of the trace element Ce exceeds the specified amount;
for Comparative Example 14, because the content of the trace element Mg exceeds the specified amount;
for Comparative Example 15, because the total content of the trace elements exceeds the specified amount;
for Comparative Example 16, because the total content of the trace elements exceeds the specified amount;
for Comparative Example 17, because the content of the alloying element Pt falls short of the specified amount.

For the comparative examples corresponding to the second group:
for Comparative Example 18, because the content of the trace element Ce falls short of the specified amount;
for Comparative Example 19, because the content of the trace element Ca exceeds the specified amount;
for Comparative Example 20, because the content of the trace element Mg exceeds the specified amount;
for Comparative Example 21, because the total content of the trace elements exceeds the specified amount, and the content of the trace element Ca exceeds the upper limit, and moreover the the trace elements Be and Si as the objective of the present invention are not contained in combination;
for Comparative Example 22, because the content of the alloying element Pd falls short of the specified amount;
for Comparative Example 23, because the total content of the alloying elements Pd and Pt exceeds the specified amount.

The alloy of the present invention is suitable for bonding wires used in automotive semiconductor devices, in particular, and in semiconductors for service under ambience sometimes becoming hot.

## Claims

1. An Au alloy bonding wire comprising an Au alloy in which trace elements are contained in an Au alloy matrix containing 0.05 to 2 mass % in total of at least one selected from Pd and Pt of high purity of at least 99.9 mass % in Au of high purity of at least 99.99 mass %;
wherein said trace elements comprise 10 to 100 ppm by mass of Mg, 5 to 100 ppm by mass of Ce, and 5 to 100 ppm by mass of each at least one selected from Be, Y, Gd, La, Eu and Si, the total content of Be, Y, Gd, La, Eu and Si being 5 to 100 ppm by mass.

2. An Au alloy bonding wire comprising an Au alloy in which trace elements are contained in an Au alloy matrix containing 0.05 to 2 mass % in total of at least one selected from Pd and Pt of high purity of at least 99.9 mass % in Au of high purity of at least 99.99 mass %;
wherein said trace elements comprise 10 to 100 ppm by mass of Mg, 5 to 100 ppm by mass of Be, and at least one selected from Y, La, Eu and Si, the content of each of Y, La, Eu and Si among the trace elements being 5 to 100 ppm by mass, and the total content of Y, La, Eu and Si being 100 ppm by mass or lower.

3. An Au alloy bonding wire comprising an Au alloy in which trace elements are contained in an Au alloy matrix containing 0.05 to 2 mass % in total of at least one selected from Pd and Pt of high purity of at least 99.9 mass % in Au of high purity of at least 99.99 mass %;
wherein said trace elements comprise 10 to 100 ppm by mass of Mg, 5 to 30 ppm by mass of Si, 5 to 30 ppm by mass of Be, and 5 to 30 ppm by mass of either of Ca and Sn.

4. An Au alloy bonding wire comprising an Au alloy in which trace elements are contained in an Au alloy matrix containing 0.05 to 2 mass % in total of at least one selected from Pd and Pt of high purity of at least 99.9 mass % in Au of high purity of at least 99.99 mass %;
wherein said trace elements comprise 10 to 100 ppm by mass of Mg, 5 to 30 ppm by mass of Si, 5 to 30 ppm by mass of Be, and 5 to 30 ppm by mass each of, and 10 to 60 ppm by mass in total of, two selected from Ca, Ce and Sn.

5. An Au alloy bonding wire comprising an Au alloy in which trace elements are contained in an Au alloy matrix containing 0.05 to 2 mass % in total of at least one selected from Pd and Pt of high purity of at least 99.9 mass % in Au of high purity of at least 99.99 mass %;
wherein said trace elements comprise 10 to 100 ppm by mass of Mg, 5 to 30 ppm by mass of Si, 5 to 30 ppm by mass of Be, and 5 to 30 ppm by mass each of, and 15 to 90 ppm by mass in total of, all three of Ca, Ce and Sn.

6. The Au alloy bonding wire according to any of claims 1 through 5, wherein the total content of said trace elements is 100 ppm by mass or lower.

7. The Au alloy bonding wire according to any of claims 1 through 5, having a wire diameter of 23 µm or smaller.
